# FASCICULE DE BREVET EUROPEEN

(11) **EP 0 983 609 B1**
(45) Date de publication et mention de la délivrance du brevet: **02.01.2002**
(21) Numéro de dépôt: 98925745.6
(22) Date de dépôt: 19.05.1998
(51) Int. Cl.: H01L 21/00, G01P 15/08

(54) **PROCEDE DE FABRICATION D'UN MICRO-CAPTEUR EN SILICIUM USINE**
VERFAHREN ZUR HERSTELLUNG EINES MIKROSENSORS MIT MIKROGEFERTIGTEM SILIZIUM
METHOD FOR MAKING A MACHINED SILICON MICRO-SENSOR

(30) Priorité: 23.05.1997 FR 9706333
(43) Date de publication de la demande: 08.03.2000
(73) Titulaire: THALES AVIONICS S.A., 78141 Vélizy Villacoublay Cédex (FR)
(72) Inventeur: LEFORT, Olivier Thomson-CSF Protection & Conseil, 94117 Arcueil Cedex (FR); THOMAS, Isabelle Thomson-CSF Protection & Conseil, 94117 Arcueil Cedex (FR)
(74) Mandataire: Guérin, Michel
(86) Numéro de dépôt international: FR9800998
(87) Numéro de publication internationale: WO9853483

(56) Documents cités:
- EP-A- 0 468 071
- US-A- 5 006 202
- US-A- 5 415 726
- US-A- 5 484 073

## Description

L'invention concerne la réalisation de microcapteurs usinés en silicium, notamment des accéléromètres pour applications d'aide à la navigation dans les aéronefs, et des capteurs de pression.

On a déjà proposé dans la technique diverses réalisations de tels capteurs, et en particulier des capteurs réalisés par superposition de trois plaques de silicium assemblées par collage ou soudage, les plaques étant usinées en partie avant assemblage et en partie après assemblage. La plaque centrale comporte des éléments mécaniques directement actifs, c'est-à-dire sur lesquels s'exerce l'accélération dans le cas d'un accéléromètre, la pression dans le cas d'un capteur de pression; elle comporte aussi des éléments électriques nécessaires au fonctionnement. Les plaques supérieure et inférieure encadrent la plaque centrale et portent éventuellement des éléments électriques nécessaires au fonctionnement, en complément des éléments électriques de la plaque centrale (notamment des connexions électriques).

Un des problèmes principaux qui se posent dans la fabrication de ces capteurs est la gravure de certains éléments de la plaque centrale, et tout particulièrement des éléments qui demandent une grande précision de micro-usinage en raison de leur rôle dans le capteur.

C'est le cas en particulier pour les éléments de suspension mobiles du micro-capteur, c'est-à-dire les éléments mécaniques qui subissent des mouvements ou des contraintes en fonction des paramètres qu'on cherche à mesurer (accélérations, pression, etc.).

Typiquement, dans un accéléromètre comportant une masse sensible attachée à un bâti fixe par des éléments de suspension et une poutre résonante, le problème réside dans la gravure des éléments de suspension et de la poutre résonante. De même, dans un capteur de pression comportant une plaque mince subissant une pression et transmettant ses déformations aux extrémités d'une poutre résonante, le problème réside surtout dans la gravure de la poutre résonante et des éléments par lesquels elle est reliée à la plaque mince.

Pour obtenir une précision de gravure suffisante sur les largeurs et épaisseurs de ces poutres, on est actuellement obligé de recourir à des structures de plaques de silicium complexes, avec couches d'oxydes de silicium intégrées dans l'épaisseur de la plaque (structures à plusieurs épitaxies ou structures à couches d'oxyde implantées), ce qui est coûteux. Sinon, la gravure est insuffisamment précise alors que les performances du capteur dépendent justement de la précision de gravure. On a pu constater par exemple que la précision de gravure de la poutre n'est pas suffisante lorsque la poutre est gravée par attaque chimique sur ses deux faces à travers un masque déposé sur une face.

Enfin, d'une manière générale, l'usinage des éléments de la plaque centrale est rendu particulièrement difficile du fait qu'il faut prévoir, outre la gravure des éléments actifs, d'autres gravures, y compris des gravures très profondes pouvant aller jusqu'à une séparation complète entre une zone centrale active et un cadre périphérique, ces gravures profondes devant être exécutées sans nuire aux gravures partielles des éléments actifs. Il en résulte que le procédé de fabrication doit prendre en compte de nombreuses contraintes et la présente invention a pour objet de proposer de réaliser certaines étapes de fabrication d'une manière avantageuse tout en étant compatible avec les nombreuses autres étapes qui doivent être exécutées pour arriver à un capteur opérationnel.

Le document US-A-5 415 726 décrit la fabrication d'un accéléromètre dans lequel une masse sismique est taillée dans un premier substrat, la masse sismique étant reliée à un cadre par une membrane continue ayant l'épaisseur finale de la poutre. Après soudure de ce premier substrat à un second, la membrane est sélectivement gravée pour former une (ou plusieurs) poutres.

Pour trouver un compromis efficace entre les problèmes de précision, de compatibilité avec les différentes opérations de micro-usinage, et de coût de fabrication, la présente invention propose un procédé de micro-usinage d'une poutre d'un micro-capteur comportant au moins deux plaques dont la première au moins est en silicium micro-usiné, ce procédé étant caractérisé en ce que :
- on réalise, par micro-usinage du silicium sur la première plaque, une poutre ayant une épaisseur égale à l'épaisseur finale désirée, et une largeur supérieure à la largeur finale désirée, la poutre étant revêtue sur sa face supérieure d'un masque définissant la largeur finale désirée;
- on assemble les deux plaques;
- on oxyde la face inférieure et les parties de la face supérieure de la poutre non recouvertes par le masque, pour les recouvrir d'une couche de protection mince;
- on enlève, par gravure directive verticale, cette couche de protection mince sur la face supérieure sans enlever le masque déjà présent;
- on attaque le silicium dans la zone dénudée par l'opération précédente, au moyen d'une gravure par la face supérieure, jusqu'à supprimer toute la partie de poutre non protégée par le masque et ainsi constituer la poutre ayant la largeur désirée.

A ce stade, on peut enlever la couche de protection et le masque précédent, lequel est d'ailleurs de préférence en oxyde de silicium comme la couche de protection.

Parmi les avantages du procédé selon l'invention, on peut noter que dans le cas où la gravure de la couche de protection doit se faire en présence d'un masque (et c'est le cas lorsqu'on veut que d'autres éléments tels que des éléments de suspension soient protégés pendant l'attaque du silicium), il est plus facile de mettre ce masque sur les plaques assemblées que sur une plaque unique qui a été fragilisée par des réductions d'épaisseur importantes.

De plus, dans le cas où les éléments actifs gravés sur la première plaque sont entourés d'un cadre entretoise physiquement séparé des éléments actifs mais usiné à partir de la même plaque, des attaches provisoires sont conservées entre le cadre et les éléments actifs, jusqu'à l'assemblage des deux plaques, et ces attaches provisoires ne sont éliminées qu'après l'assemblage, pendant l'opération d'attaque directive du silicium.

En pratique, avant l'assemblage des plaques, l'usinage de la poutre comprend les opérations suivantes :
- dépôt d'une couche de protection contre la gravure du silicium sur une largeur supérieure à la largeur de la poutre désirée, cette couche étant plus épaisse sur une largeur correspondant à la largeur finale désirée pour la poutre;
- attaque du silicium à la fois par la face supérieure et la face inférieure en une ou plusieurs étapes, jusqu'à donner à la poutre l'épaisseur finale désirée;
- enlèvement de la couche de protection sur les bords de la poutre de part et d'autre de la largeur finale désirée, en conservant une partie de couche de protection ayant la largeur finale désirée.

Dans le cas d'un accéléromètre comportant une masse sismique reliée à un pied non seulement par la poutre mais également par des bras de suspension situés dans le plan médian de l'épaisseur de la première plaque, on effectue d'abord, sur la première plaque seule, une première étape d'attaque du silicium par la face supérieure et la face inférieure, cette première étape se terminant lorsque les bras de suspension usinés à la fois par le haut et par le bas ont atteint une épaisseur désirée ; puis on oxyde ces bras de suspension pour les protéger pendant la suite de l'attaque de silicium.

D'autres caractéristiques et avantages de l'invention apparaîtront à la lecture de la description détaillée qui suit et qui est faite en référence aux dessins annexés dans lesquels :
- la figure 1 représente une coupe verticale d'un accéléromètre réalisé par le procédé selon l'invention;
- la figure 2 représente une vue horizontale de dessus de la plaque centrale de l'accéléromètre.
- la figure 3 représente l'organigramme général du procédé de fabrication de l'accéléromètre;
- les figures 4 et 5 représente les étapes de fabrication successives de la plaque inférieure de silicium;
- les figures 6 et 7 représentent les étapes de fabrication successives de la plaque supérieure;
- les figures 8, 9, et 10 représentent les étapes de fabrication successives de la plaque centrale;
- la figure 11 représente les étapes réalisées une fois la plaque inférieure et la plaque centrale assemblées;
- la figure 12 représente les étapes finales lorsque les trois plaques sont assemblées.

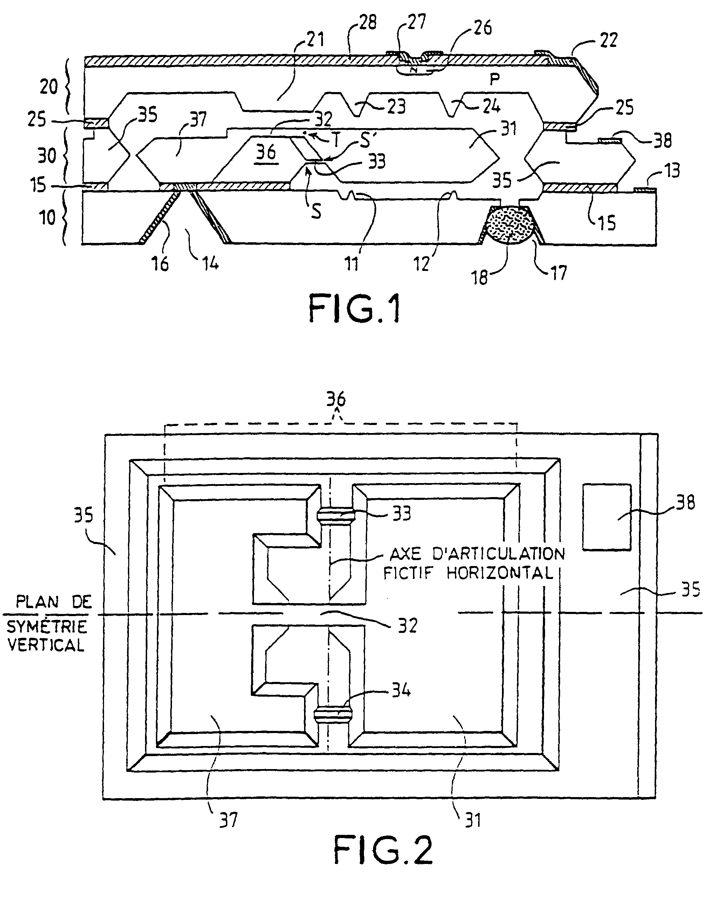

Le procédé de fabrication selon l'invention est applicable à divers capteurs en silicium micro-usiné et sera décrit à propos d'un accéléromètre dont la structure générale est représentée aux figures 1 et 2.

L'accéléromètre est constitué par la superposition de trois plaques de silicium conducteur usiné, 10, 20, 30, soudées entre elles en restant séparées les unes des autres par des couches d'oxyde de silicium 15 et 25.

La figure 2 représente une vue de dessus de la plaque centrale 30, dans laquelle on a usiné en particulier une masse sismique 31, une poutre résonante 32 reliée à la masse sismique, et des bras de suspension latéraux 33 et 34. La plaque centrale a une structure globalement symétrique par rapport à un plan médian vertical passant par le milieu de la poutre résonante le long de celle-ci. Les bras de suspension latéraux 33 et 34 sont disposés symétriquement de part et d'autre de ce plan de symétrie.

La plaque centrale 30 est en réalité constituée de deux parties bien distinctes qui sont électriquement isolées l'une de l'autre et qui pour cette raison ont été complètement séparées physiquement l'une de l'autre par gravure lors de la fabrication de l'accéléromètre. La première partie 35 est un cadre périphérique continu entourant toute la deuxième partie qui est la partie active 36 de l'accéléromètre. Le cadre périphérique 35 sert essentiellement d'entretoise de liaison entre la plaque inférieure 10 et la plaque supérieure 20 pour maintenir ces deux plaques écartées l'une de l'autre. Mais il sert aussi de blindage électrique entre les plaques 10 et 20. La partie active 36 de la plaque centrale est entièrement située entre les plaques inférieure et supérieure, et à l'intérieur du cadre périphérique 35.

La partie active comprend essentiellement :
- un pied fixe 37 soudé sur la plaque inférieure 10, et relié électriquement à cette plaque; ce pied a, vu de dessus, une forme de U dont l'ouverture est tournée vers la masse sismique;
- la masse sismique 31 déjà mentionnée; son épaisseur est égale ou presque égale à l'épaisseur de la plaque centrale; elle est maintenue au pied 37 par une suspension en porte-à-faux (32, 33, 34) ;
- la poutre résonante 32, reliée d'un côté à la masse sismique et de l'autre au pied fixe, la liaison étant placée au centre du U; son épaisseur est très faible par rapport à l'épaisseur de la masse sismique; elle est disposée sensiblement dans le plan supérieur de la plaque centrale de façon à être assez proche de la plaque supérieure; elle forme en effet un condensateur avec la portion 21 de plaque supérieure qui est directement en vis-à-vis d'elle;
- les bras de suspension latéraux 33 et 34, qui sont des lames minces horizontales; ils sont reliés à la masse sismique d'une part et au pied fixe 37 d'autre part, l'un à l'extrémité d'une première branche du U, l'autre, symétriquement, à l'extrémité de la deuxième branche du U; leur épaisseur est encore plus faible que celle de la poutre formant résonateur et ils sont de préférence situés dans un plan horizontal sensiblement médian de la plaque centrale, c'est-à-dire dans un plan passant pratiquement par le centre de gravité de la masse sismique.

Les trois plaques de silicium sont électriquement conductrices, car elles participent directement au fonctionnement électrique du micro-accéléromètre; elles sont de préférence en silicium fortement dopé de type P (dopage au bore). Des contacts métalliques sont formés par dépôt et gravure (d'aluminium par exemple) sur la plaque inférieure (contact 13 sur le bord de la plaque), sur le cadre périphérique 35 de la plaque centrale (contact 38 sur le bord extérieur du cadre), et sur la plaque supérieure (contact 22 sur le bord de la plaque), pour relier chacune de ces plaques à un circuit électrique résonant auquel est connectée la structure décrite.

La plaque inférieure 10 est micro-usinée avec les particularités suivantes :
- la zone en regard de la masse sismique est attaquée pour définir précisément des butées, 11, 12 par exemple sous forme de pyramides ponctuelles ou de bandes étroites; ces butées permettent d'éviter une rupture de la poutre 32 ou des bras de suspension 33, 34 en cas de choc ou d'accélération trop forte dans le sens vertical;
- d'autre part on s'arrange pour établir un contact électrique entre la plaque inférieure et le pied 37 de maintien de la masse sismique; le moyen préféré pour cela est une ouverture 14 creusée dans la plaque inférieure sur toute sa profondeur et à travers la couche d'oxyde de silicium 15; un dépôt conducteur 16 est réalisé dans cette ouverture pour relier électriquement la plaque 10 et le pied 37; cette structure permet de transmettre, à la poutre résonante 32, par conduction du silicium, une tension électrique appliquée au contact 13 de la plaque inférieure, la poutre constituant alors directement du fait de sa conduction propre, une armature de condensateur;
- enfin, dans le cas où la cavité contenant la masse sismique doit être vidée pour limiter le plus possible l'amortissement de la vibration de la poutre résonante, on peut prévoir d'usiner par gravure chimique une ouverture 17 à travers toute l'épaisseur de la plaque 10; cette ouverture peut être métallisée puis fermée par un bouchon 18 (en indium notamment ou alliage à bas point de fusion) pour sceller la cavité après l'avoir vidée.

La plaque supérieure 20 comporte quant à elle les parties gravées suivantes :
- pour éviter les couplages capacitifs parasites entre la plaque supérieure et la partie active 36 de la plaque centrale, la plaque supérieure est gravée profondément partout où elle est en regard de cette partie active, sauf bien entendu là où le couplage capacitif est désiré et sert à la mesure de l'accélération, à savoir dans la partie 21 située exactement au dessus de la poutre de suspension 32.
- en regard de la masse sismique, la plaque supérieure est gravée profondément mais des butées très localisées 23, 24 sont laissées pour empêcher que la masse sismique ne se déplace trop loin, ce qui risquerait de casser les poutres de suspension en cas de choc notamment;
- enfin, la plaque supérieure n'est pas gravée en regard du cadre périphérique 35 de la plaque centrale.

Les accélérations subies par la masse sismique se traduisent par une tension plus ou moins grande de la poutre résonante. Le condensateur formé par cette poutre et la plaque supérieure de silicium est placé dans un circuit résonant dont la fréquence de résonance dépend de la tension exercée donc de l'accélération.

Dans une réalisation préférentielle, une diode de compensation des variations de température est prévue dans le circuit résonant dans lequel agit le condensateur. On peut alors réaliser la diode par diffusion dans l'une des plaques de silicium, la diffusion étant de type N si les plaques sont de type P. Une solution facile consiste à prévoir une diffusion de type N, formant une région diffusée 26, dans la partie supérieure de la plaque supérieure 20, avec une électrode de contact 27 déposée sur cette région diffusée 26. Cette électrode de contact est réalisée par une métallisation (d'aluminium par exemple) qui rejoint (d'une manière non visible sur les figures) un bord de la plaque supérieure pour permettre une liaison avec l'extérieur de la structure. La métallisation est déposée au dessus d'une couche isolante 28 (oxyde de silicium par exemple) qui recouvre l'ensemble de la plaque supérieure à l'exception des zones de prise de contact avec la plaque et avec la région diffusée 26.

On va maintenant décrire les étapes de fabrication du capteur.

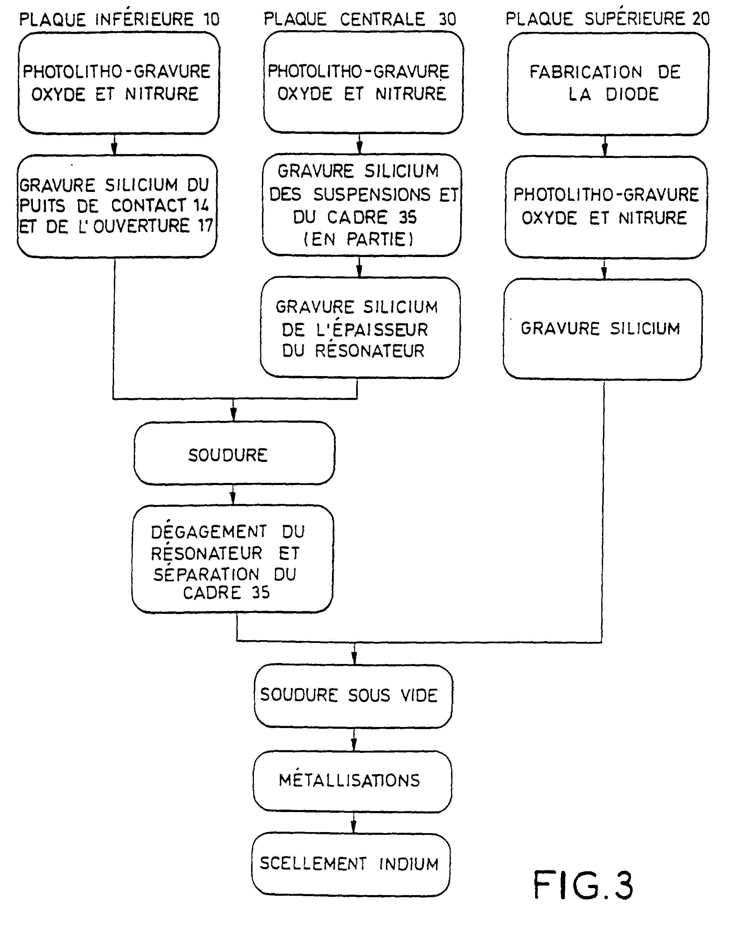

La figure 3 représente un organigramme général des différentes étapes de fabrication. Certaines étapes sont réalisées séparément sur la plaque inférieure, la plaque supérieure ou la plaque centrale, avant l'assemblage de ces plaques avec les autres. Puis des étapes sont réalisées après assemblage de la plaque inférieure et la plaque centrale. Enfin des étapes sont réalisées après assemblage des trois plaques.

D'une manière générale, la plaque inférieure 10 subit des étapes d'oxydation, de dépôt de nitrure de silicium, de photogravure d'oxyde de silicium et de nitrure de silicium, le nitrure de silicium étant utilisé comme masque de gravure de l'oxyde, puis une gravure de silicium sur la face supérieure pour la définition des butées 11, 12 et sur la face inférieure pour la définition des ouvertures 14 et 17.

La plaque supérieure 20 subit pendant ce temps des opérations d'oxydation, de gravure d'oxyde de silicium, de dopage pour la fabrication de la diode (région 26); puis des opérations de dépôt de nitrure de silicium, de photogravure d'oxyde et de nitrure de silicium, et de gravures successives de silicium sur la face inférieure pour définir les butées 23, 24, et la surface de la région 21 formant une électrode de condensateur.

La plaque centrale subit pendant ce temps les opérations suivantes : oxydation, dépôt de nitrure de silicium, gravure d'oxyde, gravures chimiques successives de silicium avec masquages successifs, pour définir successivement la configuration du pied 37, de la masse sismique 31, des bras de suspension 33, 34, et l'épaisseur de la poutre 32 (mais pas sa largeur finale).

La plaque inférieure et la plaque centrale sont alors soudées ensemble. Une opération de gravure finale de la poutre résonante et de séparation complète du cadre entretoise 35 est ensuite effectuée.

Finalement, la plaque supérieure est soudée sur la plaque centrale, les métallisations sont déposées, sur les faces extérieures de l'ensemble, aucune métallisation n'étant nécessaire dans l'espace enfermé par les plaques supérieure et inférieure à l'intérieur du cadre entretoise 35. La cavité formée dans cet espace est fermée hermétiquement par un scellement en indium ou alliage à base d'indium.

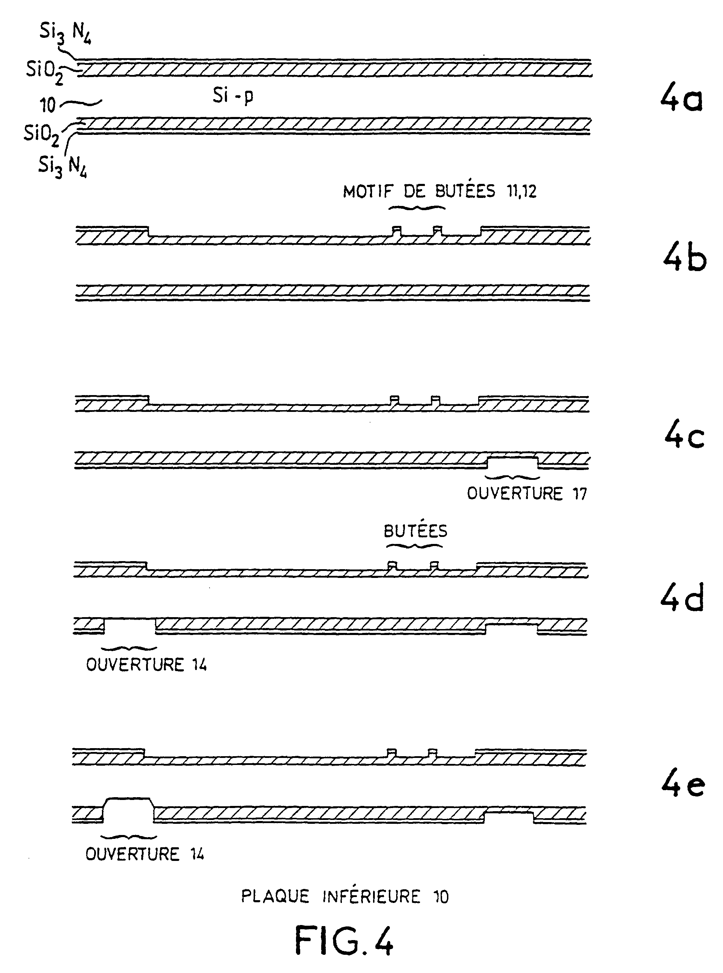

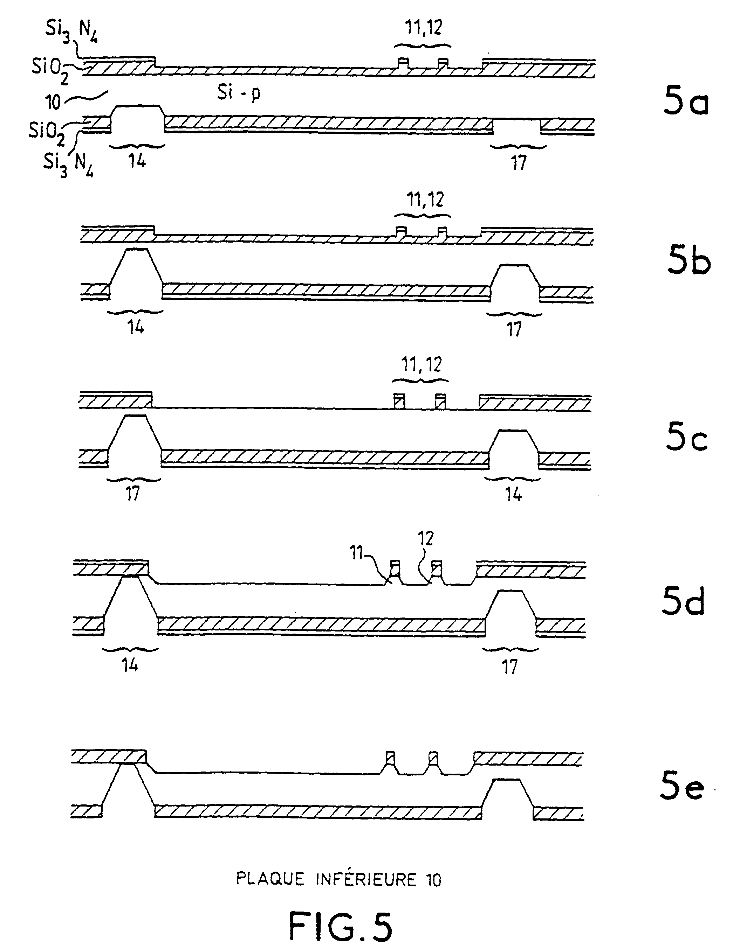

Les opérations principales de fabrication vont être détaillées en référence aux figures 4 et 5 pour la plaque inférieure, 5 et 7 pour la plaque supérieure, 8,9, 10 pour la plaque centrale, 11 pour les plaques inférieure et centrale assemblées, et 12 pour les trois plaques assemblées. On fera attention que sur les figures 4 à 11, on a juxtaposé différentes zones subissant des opérations variées sans placer ces zones dans leur configuration réelle les unes par rapport aux autres, ceci afin de simplifier la description du procédé.

### Plaque inférieure 10 :

Sur les deux faces de la plaque de silicium inférieure 10, on fait croître une couche d'oxyde de silicium de un ou plusieurs micromètres d'épaisseur, elle-même revêtue d'une fine couche de nitrure de silicium (figure 4a).

On grave la couche de nitrure de la face supérieure selon un motif définissant la zone en regard de la masse sismique, en réservant le nitrure à l'endroit des butées inférieures 11, 12 de la figure 1; et on attaque l'oxyde sur une partie de sa profondeur là où le nitrure a été enlevé (figure 4b).

On grave la couche de nitrure de la face inférieure selon un motif définissant l'ouverture 17 et on attaque l'oxyde sur une partie de sa profondeur dans ce motif (figure 4c).

On grave le nitrure à nouveau sur la face inférieure selon un motif définissant l'ouverture de contact 14, et on enlève complètement l'oxyde dans cette région, en ayant préalablement masqué l'ouverture 17 et la face supérieure de la plaquette pour y conserver l'oxyde (figure 4d).

On attaque le silicium sur plusieurs dizaines de micromètres de profondeur dans l'ouverture 14 (figure 4e).

D'une manière générale, les attaques de silicium sont faites par voie chimique, ce qui produit des flancs obliques, sauf lorsqu'il sera précisé que la gravure est une gravure directive verticale.

On enlève ensuite l'oxyde dans l'ouverture 17 (figure 5a), et on attaque à nouveau le silicium jusqu'à ne laisser que quelques dizaines de micromètres d'épaisseur au niveau de l'ouverture 17, et moins encore dans l'ouverture 14 qui était déjà partiellement creusée (figure 5b).

On enlève ensuite ce qui reste d'oxyde de silicium non protégé par du nitrure sur la face supérieure (figure 5c).

On attaque le silicium à nouveau là où il n'est plus protégé par de l'oxyde, à savoir en regard de la masse sismique (sauf les butées) sur la face supérieure, et dans les ouvertures 14 et 17 sur la face inférieure. L'attaque du silicium dans l'ouverture 14 se produit jusqu'à la face supérieure et s'arrête sous l'oxyde qui recouvre cette face. Les butées 11, 12 sont définies sur la face supérieure. L'ouverture 17 n'est pas complètement percée à ce stade (figure 5d).

Le nitrure est complètement enlevé sur les deux faces et la plaque inférieure est prête à être assemblée à la plaque centrale (figure 5e).

### Plaque supérieure 20 :

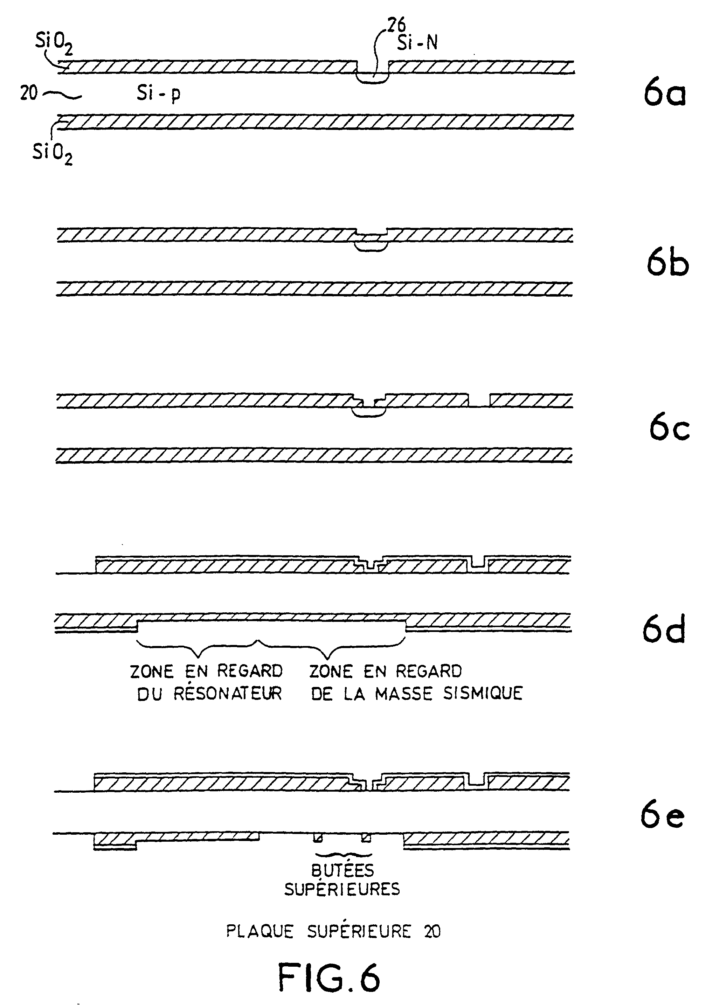

Les opérations concernant la plaque supérieure seule sont représentées sur les figures 6 (6a à 6e) et 6 (7a à 7d).

La plaque supérieure 20 est oxydée sur ses deux faces, une ouverture est formée dans l'oxyde de la face supérieure pour définir la diode de compensation de température, et la zone de silicium 26 ainsi découverte est dopée, par exemple avec du phosphore (figure 6a).

La zone 26 est oxydée pendant ou après l'opération de dopage (figure 6b).

Deux ouvertures sont photogravées dans la couche d'oxyde de la face supérieure, respectivement une ouverture d'accès à la diode et une ouverture pour la métallisation 22 d'accès à la plaque (figure 6c).

Les deux faces de la plaque sont recouvertes de nitrure de silicium et le nitrure de la face inférieure est photogravé pour définir les zones de silicium qu'on doit creuser pour les éloigner de la plaque centrale en vue de réduire les capacités parasites entre plaque centrale et plaque supérieure; dans ces zones, ainsi que dans la zone 21 qui sera en regard de la poutre résonante, l'oxyde de silicium est enlevé sur une partie de son épaisseur seulement (figure 6d). Sur la face supérieure, l'oxyde est enlevé sur toute son épaisseur sur un bord de la plaque seulement.

Sur la face inférieure de la plaque 20, l'oxyde subit une opération de photogravure et est enlevé d'une part en regard de la masse sismique, sauf là où il faut définir des butées supérieures 23, 24, et d'autre part sur le bord de la plaque; il n'est pas enlevé dans la zone qui sera en regard de la poutre résonante (figure 6e).

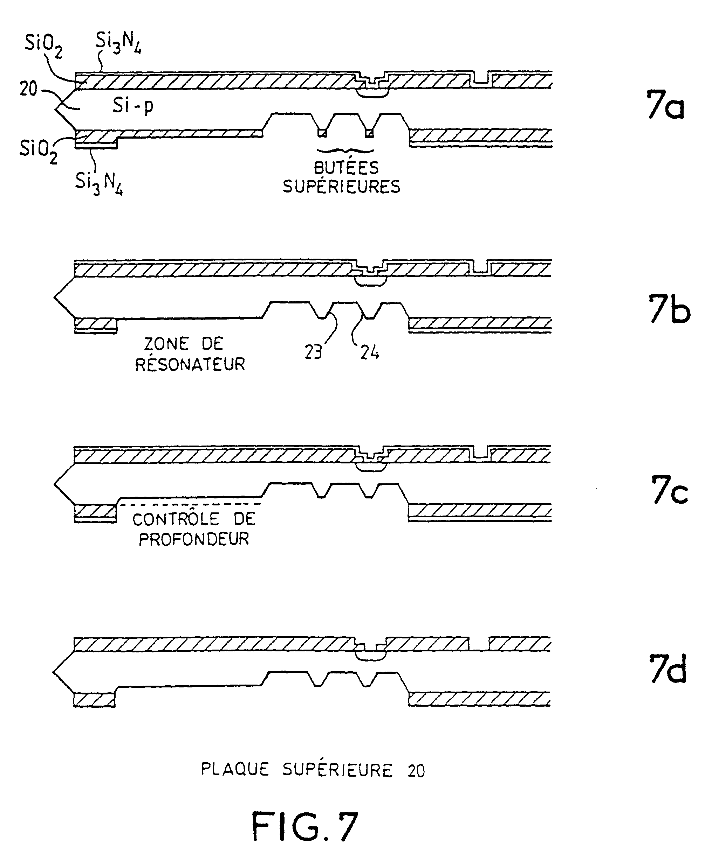

Le silicium est attaqué chimiquement là où il est dénudé, à savoir sur le bord de la plaque (sur les deux faces) et, sur la face inférieure, dans la zone située en regard de la masse sismique à l'exception des butées 23, 24 qui sont ainsi réalisées (figure 7a).

L'oxyde de silicium subsistant au dessus des butées et dans la zone en regard de la poutre résonante est enlevé (figure 7b).

Une gravure supplémentaire du silicium est effectuée dans les zones ou le silicium reste dénudé, ce qui permet de bien contrôler l'espacement entre la plaque supérieure et la plaque centrale à l'endroit de la poutre résonante. Le contrôle de cet espacement est en effet un paramètre important de qualité du capteur (figure 7c).

Enfin, le nitrure de silicium est enlevé sur les deux faces et la plaque supérieure est prête à être soudée à la plaque centrale (figure 7d).

### Plaque centrale 30 :

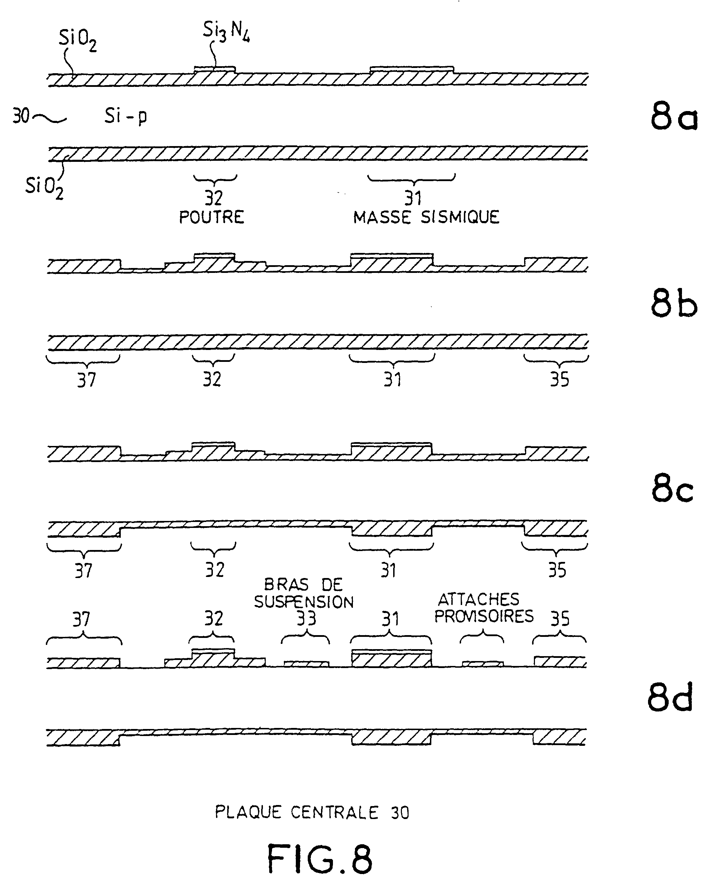

Les opérations concernant la plaque centrale seule sont décrites en référence aux figures 8 (8a à 8d), 9 (9a à 9d), (10a à 10d).

Pour faciliter les explications de procédé de fabrication, on a considéré sur ces figures que les zones suivantes sont juxtaposées même si dans la réalité elles ne sont pas côte à côte : pied 37 de la masse sismique; résonateur 32, bras de suspension 33, masse sismique 31, zone de séparation physique entre partie active 36 et cadre entretoise 35, et enfin cadre entretoise 35 lui-même.

On fait croître sur les deux faces de la plaque centrale 30 une couche d'oxyde de silicium et on dépose sur la face supérieure une couche de nitrure de silicium que l'on grave pour ne laisser subsister le silicium que dans les zones correspondant à la poutre résonante 32 et à la masse sismique 31 (figure 8a).

L'oxyde de silicium mis à nu est photogravé (masque de résine) sur la face supérieure pour permettre de réduire son épaisseur à peu près partout sauf sur les bords latéraux de la poutre résonante, sur le pied 37, et sur le cadre entretoise 35 (figure 8b).

De même, sur la face inférieure, l'oxyde de silicium est photogravé pour réduire son épaisseur partout sauf à l'endroit de la masse sismique, du pied 37 et du cadre entretoise 35 (figure 8c).

Un masque de photogravure de l'oxyde de silicium est mis en place sur la face supérieure pour définir un motif de protection du silicium au dessus des bras de suspension 33, 34 et des attaches provisoires entre cadre 35 et reste de la plaque centrale, attaches qui seront supprimées après assemblage de la plaque centrale sur la plaque inférieure. L'oxyde de silicium est enlevé sur une épaisseur de quelques dixièmes de micromètres pour dénuder le silicium sur la face supérieure de la plaque centrale, à l'exception des zones suivantes où il reste protégé par de l'oxyde : cadre entretoise 35, poutre résonante 32 et bords latéraux de part et d'autre de la poutre, masse sismique, bras de suspension 33, attaches provisoires 35'. (figure 8d).

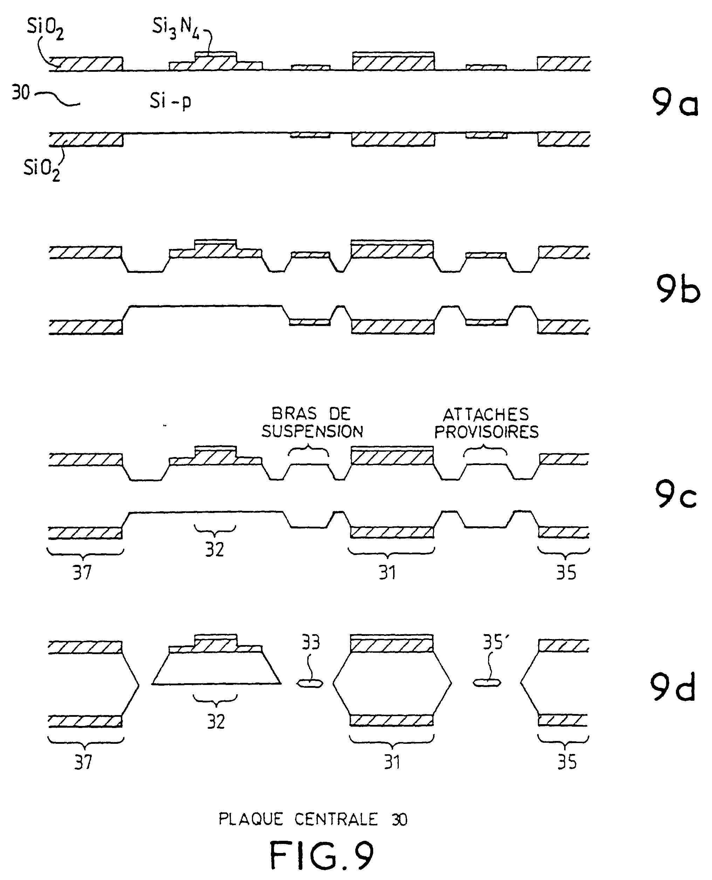

De même, un masque de photogravure de l'oxyde de silicium est mis en place sur la face inférieure, identique à celui de la face supérieure à l'exception du fait que le silicium ne doit pas être protégé au dessous de la poutre résonante 32 ni sur ses bords. L'oxyde de silicium est enlevé pour dénuder le silicium sauf à l'endroit du cadre 35, de ses attaches provisoires, de la masse sismique, et des bras de suspension 33 (figure 9a).

Le silicium est gravé par attaque chimique sur les deux faces à la fois, pour commencer la gravure là où il est dénudé (figure 9b).

Puis, on enlève la faible épaisseur d'oxyde subsistant en regard des attaches provisoires et des bras de suspension, sur la face inférieure et la face supérieure; l'oxyde subsiste ailleurs (figure 9c).

Et on continue la gravure du silicium jusqu'à enlever complètement le silicium là où il était complètement dénudé à l'étape de la figure 9a. L'attaque du silicium se faisant à la fois par le haut et par le bas, il subsiste une configuration dans laquelle le silicium reste :
- avec son épaisseur totale à l'endroit du pied 37, du cadre 35 et de la masse sismique 31,
- avec une épaisseur sensiblement moitié de celle de la plaque initiale sous la poutre résonante 32 y compris ses bords latéraux,
- avec une faible épaisseur (une dizaine de micromètres) pour les bras de suspension 33 et les attaches provisoires désignées par 35'.

### (figure 9d)

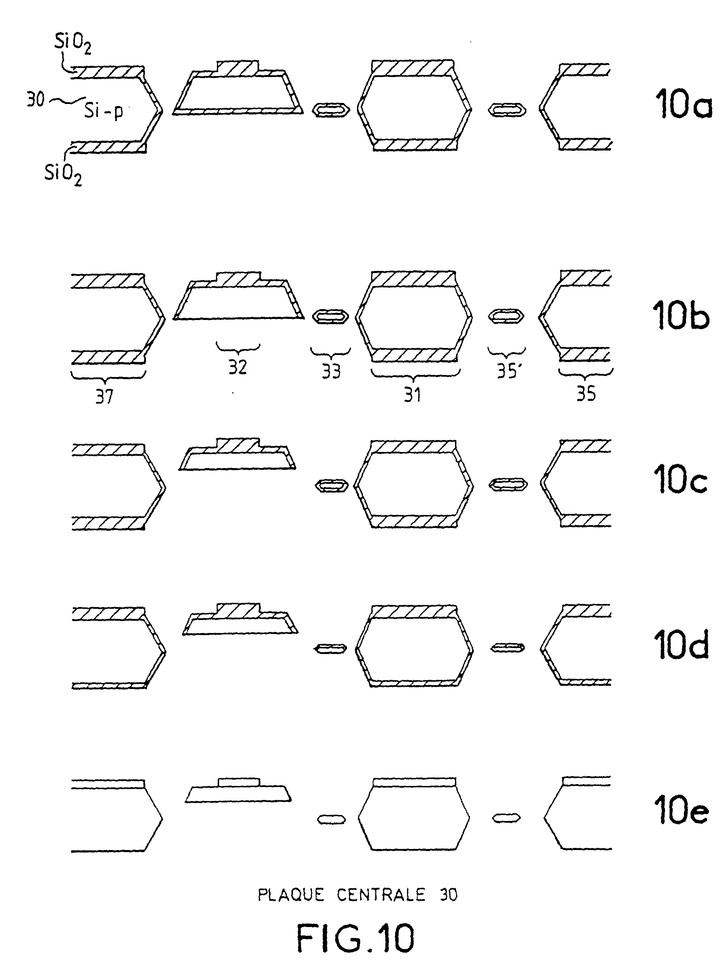

On enlève alors le nitrure de silicium toujours présent sur la face supérieure et on effectue à ce stade une opération de réoxydation fine du silicium à nu sur les deux faces. Ceci conduit à une fine couche d'oxyde de silicium sur le dessous et les côtés de la poutre résonante, et sur les dessous et les côtés des bras de suspension et des attaches provisoires (figure 10a).

On enlève alors, par gravure directive verticale à partir de la face inférieure, l'oxyde mince qui vient d'être formé, à travers un masque qui ne laisse apparaître que le silicium de la poutre résonante et les bords latéraux qui l'encadrent. Ceci dénude la face arrière de cette poutre, y compris ces bords (figure 10b).

Le silicium peut alors à nouveau être attaqué pour donner à la poutre résonante l'épaisseur finale désirée (figure 10c).

L'étape suivante consiste à enlever une partie de l'épaisseur de l'oxyde présent sur la face inférieure, par gravure directive verticale vers le haut, ce qui enlève l'oxyde sous les bras de suspension et sous les attaches provisoires 35', sans toutefois poursuivre la gravure suffisamment pour enlever l'oxyde au dessous du cadre entretoise 35 et de la masse sismique 31 (figure 10d).

Ensuite, on enlève une partie de l'épaisseur de l'oxyde présent sur la face supérieure, par gravure directive verticale vers le bas, en ne laissant subsister de l'oxyde que là où il était le plus épais, à savoir sur le cadre entretoise 35, sur la masse sismique 31, et sur la poutre résonante 32, mais pas sur les bords de cette dernière (figure 10e).

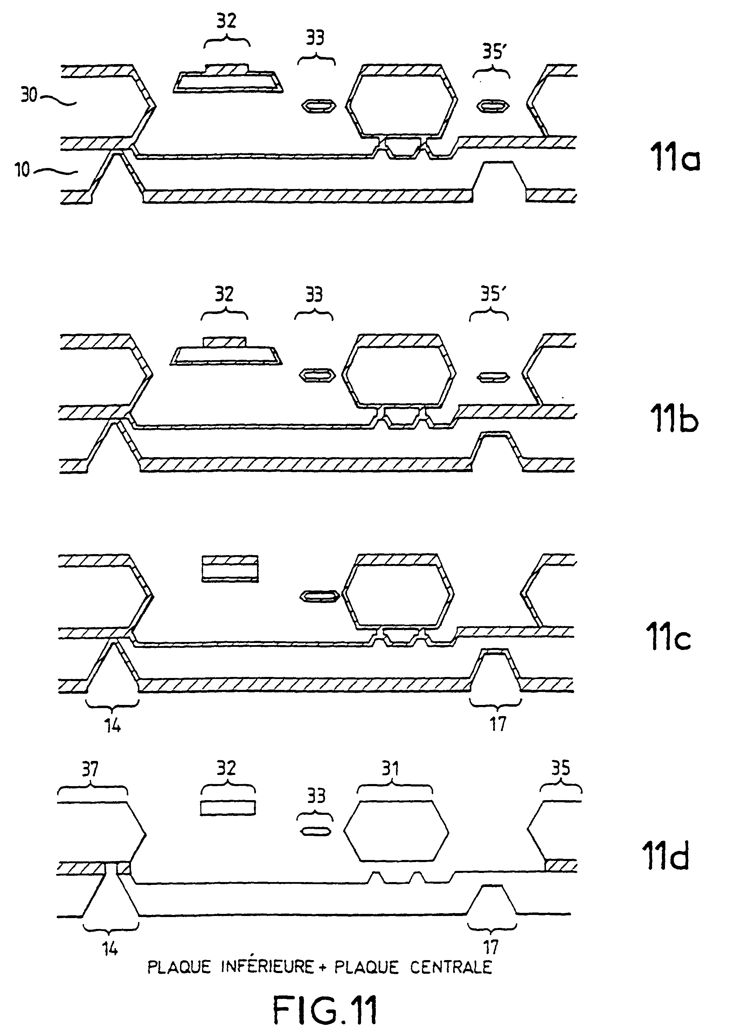

Les étapes suivantes, représentées aux figures 11 (11à à 11d) et 12 (12a à 12c), concernent l'assemblage des plaques et les opérations effectuées après assemblage.

### Assemblage plaque centrale sur plaque inférieure :

La plaque centrale 30 est placée en contact par sa face inférieure avec la face supérieure de la plaque inférieure 10 et l'ensemble est soumis à un recuit oxydant suivi d'un recuit en atmosphère neutre. Les plaques se soudent et les parties dénudées de silicium se recouvrent d'une fine couche d'oxyde de silicium (figure 11a).

En présence d'un masque, par gravure directive verticale, on enlève l'oxyde de silicium mince présent sur la partie horizontale des bords latéraux de la poutre résonante 32 et sur les attaches provisoires 35', sans dénuder le silicium sur le pied 37, le cadre 35, la poutre 32, le bras 33, et la masse sismique 31. D'autres éléments de la plaque inférieure peuvent être dénudés si on doit graver le silicium dans l'étape suivante. Les bras de suspension 33 restent en tous cas protégés (figure 11b). On comprendra que l'enlèvement sélectif de l'oxyde qui recouvre les bords latéraux de la poutre 32 est possible par suite des différences d'épaisseur d'oxyde présentes à ce stade, mais que cet enlèvement sélectif serait possible également si la poutre 32 était recouverte à ce stade d'un matériau autre que de l'oxyde de silicium, de nitrure par exemple.

On notera que l'utilisation d'un masque de gravure de l'oxyde de silicium mince est possible à ce stade car la masse sismique est maintenue en place en contact avec l'oxyde qui recouvre les butées 11, 12. De cette manière, les zones fragiles du silicium (poutre, bras de suspension) ne sont pas soumises à des contraintes sévères. Ce masque de gravure ne serait pratiquement pas utilisable sur la plaque centrale avant assemblage avec la plaque inférieure.

Une gravure du silicium est alors effectuée pour éliminer les bords latéraux de la poutre résonante 32 et lui donner ainsi sa largeur définitive. Les attaches provisoires 35' sont éliminées du même coup (figure 11c). La gravure est de préférence une gravure directive verticale (par plasma) mais elle peut être aussi une gravure chimique non directive ; dans ce dernier cas, la largeur du bras qui définit la poutre 32 doit tenir compte de la légère sous-gravure résultant de l'attaque chimique.

L'ensemble des deux plaques est soumis à une opération de désoxydation partielle qui élimine l'oxyde partout (sans éliminer l'oxyde présent sous le cadre entretoise 35 et sous le pied 37 à la jonction des plaques soudées). Pendant cette opération, l'oxyde présent entre les butées 11,12 et la masse sismique est éliminé du fait de l'étroitesse des butées. L'oxyde présent au fond des ouvertures 14 et 17 est également éliminé, et la gravure de l'oxyde est poursuivie jusqu'à dénuder le silicium de la plaque centrale dans le fond de l'ouverture 14. A la fin de cette opération, il n'y a plus d'oxyde sur les parties actives de la plaque centrale, c'est-à-dire sur la masse sismique, la poutre, et les bras de suspension (figure 11d).

A ce stade, la poutre résonante 32 a ses dimensions définitives aussi bien en largeur qu'en épaisseur. Il en est de même des bras de suspension 33, et de la masse sismique 31.

### Assemblage des trois plaques :

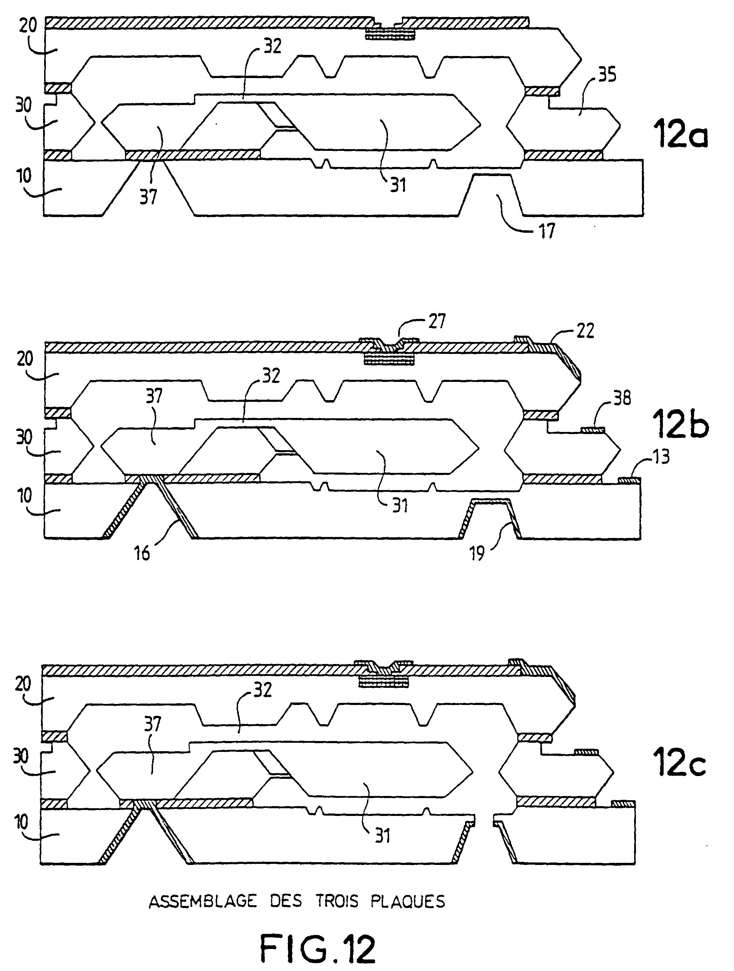

La plaque supérieure est alors rapportée sur la plaque centrale par soudure sous vide à environ 1000°C. La soudure sous vide permet de faire immédiatement le vide dans la cavité fermée contenant la masse sismique et la poutre résonante. L'ouverture 17 est toujours fermée à ce stade par une certaine épaisseur résiduelle de silicium (figure 12a).

On notera que la figure 12 représente la configuration réelle du capteur, c'est-à-dire que les différentes parties sont placées les unes par rapport aux autres à leur emplacement fonctionnel réel, contrairement à ce qui a été fait pour décrire les opérations précédentes.

Après désoxydation superficielle des zones de contact sur le silicium, on procède à un dépôt métallique par évaporation, sur les faces externes du capteur, puis à une gravure pour délimiter les contacts et dépôts métalliques à laisser sur chaque plaque : contacts 22 et 27 sur la plaque supérieure, connexion éventuelle pour ramener le contact 27 sur le bord de la plaque; contact 38 sur la plaque centrale; contact 13 sur la plaque inférieure; contact 16 sur la plaque centrale à travers l'ouverture 14 de la plaque inférieure. Tous ces contacts peuvent être en aluminium évaporé sous vide. Un dépôt séparé d'alliage chrome-or 19 peut être effectué dans l'ouverture 17, en prévision d'une soudure indium ultérieure (figure 12b).

A ce stade, le capteur peut être testé par test sous pointes, tout en ayant sa cavité fermée et sous vide, ce qui est très important.

L'opération suivante est un perçage de la membrane de silicium fermant l'ouverture 17. Le perçage est fait par laser (figure 12c).

La cavité est ensuite fermée par une bille d'indium, sous vide, pour aboutir à la structure représentée à la figure 1. Un test sous pointes peut encore être effectué à ce stade.

Les opérations de fabrication ont été décrites à propos d'un accéléromètre, mais la transposition à d'autres types de capteurs est facile. Les différences seraient typiquement les suivantes pour un capteur de pression : il n'y a pas de masse sismique suspendue et la poutre résonante est attachée entre deux pieds fixes tels que le pied 37. La plaque inférieure est très amincie dans la région séparant ces deux pieds, et les déformations de la plaque dues à la pression extérieure se traduisent par une contrainte de traction sur la poutre résonante. Les opérations de fabrication seraient globalement les mêmes, particulièrement celles qui concernent l'usinage en épaisseur et en largeur de la poutre résonante.

## Revendications

1. Procédé de micro-usinage d'une poutre (32) d'un micro-capteur comportant au moins deux plaques (10,30) dont la première au moins (30) est en silicium micro-usiné, ce procédé étant **caractérisé en ce que** :
- on réalise, par micro-usinage du silicium sur la première plaque (30), une poutre ayant une épaisseur égale à l'épaisseur finale désirée, et une largeur supérieure à la largeur finale désirée, la poutre étant revêtue sur sa face supérieure d'un masque définissant la largeur finale désirée;
- on assemble les deux plaques;
- on oxyde la face inférieure et les parties de la face supérieure de la poutre non recouvertes par ledit masque, pour les recouvrir d'une couche de protection mince;
- on enlève, par gravure directive verticale, cette couche de protection mince sur la face supérieure sans enlever le masque déjà présent;
- on attaque le silicium dans la zone dénudée par l'opération précédente, au moyen d'une gravure par la face supérieure, jusqu'à supprimer toute la partie de poutre non protégée par le masque et ainsi constituer la poutre ayant la largeur désirée.

2. Procédé selon la revendication 1, **caractérisé en ce que** l'opération de gravure du silicium dans la zone dénudée est une gravure directive verticale.

3. Procédé selon l'une des revendications 1 et 2, **caractérisé en ce que**, avant l'assemblage des plaques, l'usinage de la poutre comprend les opérations suivantes :
- dépôt d'une couche de protection contre la gravure du silicium sur une largeur supérieure à la largeur de la poutre désirée, cette couche étant plus épaisse sur une largeur correspondant à la largeur finale désirée pour la poutre;
- attaque du silicium à la fois par la face supérieure et la face inférieure en une ou plusieurs étapes, jusqu'à donner à la poutre l'épaisseur finale désirée;
- enlèvement de la couche de protection sur les bords de la poutre de part et d'autre de la largeur finale désirée, en conservant une partie de couche de protection ayant la largeur finale désirée.

4. Procédé selon la revendication 3, appliqué à la réalisation d'un accéléromètre comportant une masse sismique (31) reliée à un pied par la poutre et par des bras de suspension (32,34) situés dans le plan médian de l'épaisseur de la première plaque, (30) **caractérisé en ce que** l'attaque de silicium à la fois par la face supérieure et par la face inférieure se déroule de la manière suivante : on effectue l'attaque dans une première étape jusqu'à ce que les bras de suspension aient atteint une épaisseur désirée, on oxyde ces bras pour les protéger, et on continue l'attaque du silicium dans une deuxième étape sans attaquer les bras de suspension ainsi protégés.

5. Procédé selon l'une des revendications 1 à 4, **caractérisé en ce que** la plaque de silicium est micro-usinée pour définir un cadre entretoise périphérique (35) complètement séparé d'une partie active à l'intérieur de ce cadre, la poutre faisant partie de cette partie active, **caractérisé en ce qu'**une opération finale de séparation entre le cadre et la partie active est effectuée par enlèvement de silicium pendant l'étape de gravure de silicium qui donne à la poutre sa largeur finale désirée.

## Patentansprüche

1. Verfahren zur Mikrobearbeitung eines Trägers (32) eines Mikrosensors, der wenigstens zwei Platten (10, 30) umfaßt, wovon wenigstens die erste (30) aus mikrobearbeitetem Silicium besteht, wobei dieses Verfahren **dadurch gekennzeichnet ist, daß**:
- durch Mikrobearbeitung von Silicium auf der ersten Platte (30) ein Träger mit einer Dicke, die gleich der gewünschten Enddicke ist, und mit einer Breite, die größer als die gewünschte Endbreite ist, hergestellt wird, wobei der Träger auf seiner oberen Fläche mit einer Maske beschichtet wird, die die gewünschte Endbreite definiert;
- die beiden Platten zusammengefügt werden;
- die untere Fläche und diejenigen Teile der oberen Fläche des Trägers, die nicht mit der Maske beschichtet sind, oxidiert werden, um sie mit einer dünnen Schutzschicht zu überziehen;
- diese dünne Schutzschicht auf der oberen Fläche durch vertikale direkte Ätzung abgehoben wird, ohne daß die bereits vorhandene Maske abgehoben wird;
- das Silicium in der durch den vorhergehenden Vorgang freigelegten Zone mittels einer Ätzung durch die obere Fläche angegriffen wird, bis der gesamte durch die Maske nicht geschützte Teil des Trägers entfernt ist und somit der Träger mit der gewünschten Breite gebildet ist.

2. Verfahren nach Anspruch 1, **dadurch gekennzeichnet, daß** der Vorgang des Ätzens des Siliciums in der freigelegten Zone eine vertikale direkte Ätzung ist.

3. Verfahren nach einem der Ansprüche 1 und 2, **dadurch gekennzeichnet, daß** die Bearbeitung des Trägers vor dem Zusammenfügen der Platten die folgenden Vorgänge umfaßt:
- Ablagern einer Schicht zum Schutz vor der Ätzung von Silicium auf einer Breite, die größer als die gewünschte Breite des Trägers ist, wobei diese Schicht auf einer Breite, die der gewünschten Endbreite für den Träger entspricht, dicker ist;
- Angreifen des Siliciums zugleich durch die obere Fläche und die untere Fläche in einem oder in mehreren Schritten, bis dem Träger die gewünschte Enddicke verliehen ist;
- Abheben der Schutzschicht an den Rändern des Trägers beiderseits der gewünschten Endbreite, wobei derjenige Teil der Schutzschicht beibehalten wird, der die gewünschte Endbreite besitzt.

4. Verfahren nach Anspruch 3, das auf die Herstellung eines Beschleunigungsmessers angewendet wird, der eine seismische Masse (31) umfaßt, die durch den Träger und durch Aufhängungsarme (32, 34), die sich in der Mittelebene der Dicke der ersten Platte (30) befinden, mit einem Fuß verbunden ist, **dadurch gekennzeichnet, daß** der Angriff des Siliciums zugleich durch die obere Fläche und durch die untere Fläche in der folgenden Weise erfolgt: Ausführen eines Angriffs in einem ersten Schritt, bis die Aufhängungsarme eine gewünschte Dicke erreicht haben, Oxidieren dieser Arme, um sie zu schützen, und Fortsetzen des Angriffs des Siliciums in einem zweiten Schritt, ohne die somit geschützten Aufhängungsarme anzugreifen.

5. Verfahren nach einem der Ansprüche 1 bis 4, **dadurch gekennzeichnet, daß** die Silicium-Platte mikrobearbeitet wird, um einen Umfangsdistanzrahmen (35) zu definieren, der von einem aktiven Teil innerhalb dieses Rahmens vollständig getrennt ist, wobei der Träger einen Teil des aktiven Teils bildet, **dadurch gekennzeichnet, daß** ein abschließender Trennvorgang zwischen dem Rahmen und dem aktiven Teil durch Abheben von Silicium während des Schrittes des Ätzens von Silicium, der dem Träger seine gewünschte Endbreite verleiht, erfolgt.

## Claims

1. Process for micromachining a beam (32) of a microsensor having at least two plates (10, 30), at least the first (30) of which is in micromachined silicon, this process being **characterized in that**:
- a beam having a thickness equal to the desired final thickness, and a width greater than the desired final width, is produced by micromachining the silicon on the first plate (30), the beam being covered on its upper face by a mask defining the desired final width;
- the two plates are assembled together;
- the lower face and the parts of the upper face of the beam which are not covered by the said mask are oxidized in order to cover them with a thin protective layer;
- this thin protective layer on the upper face is removed, by vertical directional etching, without removing the mask already present;
- the silicon in the area exposed by the preceding operation is attacked by means of an etch through the upper face, until the entire part of the beam not protected by the mask is eliminated, and the beam having the desired width is thus formed.

2. Process according to Claim 1, **characterized in that** the operation of etching the silicon in the exposed area is a vertical directional etch.

3. Process according to one of Claims 1 and 2, **characterized in that**, before the plates are assembled together, machining of the beam comprises the following operations:
- depositing a layer which protects against etching of the silicon over a width greater than the width of the beam desired, this layer being thicker over a width corresponding to the final width desired for the beam;
- attacking the silicon through both the upper face and the lower face in one or more steps, until the beam is given the desired final thickness;
- removing the protective layer on the edges of the beam on either side of the desired final width, while keeping a portion of protective layer having the desired final width.

4. Process according to Claim 3, applied to the production of an accelerometer having a proof mass (31) connected to a base by the beam and by suspension arms (32, 34) located in the median plane of the thickness of the first plate (30), **characterized in that** the silicon attack through both the upper face and the lower face takes place in the following way: the attack is carried out in a first step until the suspension arms have reached a desired thickness, these arms are oxidized in order to protect them, and the attack on the silicon is continued in a second step without attacking the suspension arms thus protected.

5. Process according to one of Claims 1 to 4, **characterized in that** the silicon plate is micromachined to define a peripheral spacer frame (35) completely separated from an active part inside this frame, the beam forming part of this active part, **characterized in that** a final operation of separating the frame from the active part is carried out by removing the silicon during the silicon-etching step which gives the beam its desired final width.
